# EUROPEAN PATENT SPECIFICATION

(11) **EP 1 472 078 B1**
(45) Date of publication and mention of the grant of the patent: **28.04.2010**
(21) Application number: 02799329.4
(22) Date of filing: 27.12.2002
(51) Int. Cl.: B32B 3/10, F28D 20/02

(54) **THERMAL BARRIERS WITH REVERSIBLE ENHANCED THERMAL PROPERTIES**
WÄRMESPERREN MIT UMKEHRBAREN VERBESSERTEN WÄRMEEIGENSCHAFTEN
BARRIERES THERMIQUES A PROPRIETES THERMIQUES REVERSIBLES AMELIOREES

(30) Priority: 02.01.2002 US 37864
(43) Date of publication of application: 03.11.2004
(73) Proprietor: Outlast Technologies, Inc., Boulder, CO 80301 (US)
(72) Inventor: MAGILL, Monte, C., Longmont, CO 80501 (US); PERRY, Bernard, T., Erie, CO 80516 (US)
(74) Representative: Naylor, Matthew John
(86) International application number: PCT/US2002/041593
(87) International publication number: WO 2003/057474

(56) References cited:
- EP-A- 0 437 331
- GB-A- 2 334 428
- US-A- 4 204 016
- US-A- 5 271 980
- US-A- 5 290 904
- US-A- 5 532 039
- US-A- 5 555 932
- US-A- 6 037 033

## Description

### FIELD OF THE INVENTION

The present invention relates generally to thermal barriers and methods of manufacturing the same. More particularly, the present invention relates to thermal barriers comprising phase change materials and methods of manufacturing the same.

### BACKGROUND OF THE INVENTION

Various types of insulation, such as those used in textiles, apparel, walls and ceilings of buildings, and walls of appliances, typically rely upon reducing heat flow from or to an outside environment so that a desired temperature or range of temperatures may be maintained in an enclosed region. Traditional insulation, such as insulation utilizing fiberglass or dead air space, typically suffers from one or more disadvantages. For instance, the effectiveness of traditional insulation often depends on the amount of insulation material. Accordingly, such insulation may be bulky, inflexible, and/or difficult to install in order to provide adequate insulation capacity and may lose insulation capacity if compressed or when wet. Moreover, traditional insulation may have limited insulation capacity since it works by simply retarding heat flow and generally has a static response and, thus, is unable to respond to different conditions of the outside environment and/or the enclosed region.

Attempts at developing superior forms of insulation have led to the use of phase change materials. Rather than simply retarding heat flow, insulation incorporating a phase change material may additionally absorb and/or release thermal energy, typically as the phase change material undergoes a change of state. Typically, a microencapsulated phase change material is used. The microencapsulated phase change material may be compounded into a coating system that is applied to an insulation material, or the microencapsulated phase change material may be dispersed into a pre-solidified form of the insulation material, which is subsequently cured. The additional processing (including a ' microencapsulation process) associated with the use of microencapsulated phase change materials may lead to loss of insulation material and/or phase change material and adds further expense to a manufacturing process. Moreover, use of phase change material in a microencapsulated form may limit the amount of phase change material that can be incorporated into an insulation material to a level below a desirable level.

GB A 2334428 proposes a heat or cold insulating insole comprising a core having a 3D textile structure, the core being impregnated with at least one phase change material (PCM). EP A 0437331 proposes a free flowing, conformable powder-like mix of silica particles and a PCM. US 5290904 proposes a thermal shield with a thermal energy absorbing material comprising a PCM positioned between flat flame resistant covering layers in a sandwich fashion. US 5532039 proposes a thermal barrier including spaced apart sheets which define a chamber, a PCM material being in the chamber. US 5555932 proposes a heat shield for an automotive vehicle which utilises a PCM.

### SUMMARY OF THE INVENTION

A first aspect of the present invention provides a thermal barrier according to claim 1.

In another exemplary embodiment, the thermal barrier may comprise a first barrier layer, a second barrier layer, and a base material positioned between the first barrier layer and the second barrier layer. The base material may comprise a first region, a second region, and a barrier zone positioned between the first region and the second region. The thermal barrier may further comprise a first non-encapsulated phase change material impregnating the first region and a second non-encapsulated phase change material impregnating the second region. The barrier zone hinders migration of the first phase change material and the second phase change material in their respective liquid states within the base material, and the first barrier layer is bonded to the second barrier layer to enclose the base material. The first phase change material and the second phase change material may be the same or different.

A second aspect of the present invention provides a method for forming a thermal barrier according to claim 16.

In another exemplary embodiment, the method may comprise applying thermal energy or electromagnetic energy to an untreated base material to form a base material comprising a plurality of regions and a barrier zone separating the regions. The method may further comprise impregnating one or more of the regions with a non-encapsulated phase change material, wherein the barrier zone hinders migration of the phase change material within the base material. The method may further comprise positioning the base material between a first barrier layer and a second barrier layer and bonding the first barrier layer to the second barrier layer to enclose the base material to form the thermal barrier.

### BRIEF DESCRIPTION OF THE DRAWINGS

For a better understanding of the nature and objects of the invention, reference should be made to the following detailed description taken in conjunction with the accompanying drawings, in which:

FIG. 1 illustrates a thermal barrier in accordance with an embodiment of the invention;

FIG. 2 is a cross-sectional view of this embodiment, taken along line 2-2 of FIG. 1;

FIG. 3 illustrates a method of forming a thermal barrier, according to an embodiment of the invention;

FIG. 4 illustrates a thermal barrier in accordance with another embodiment of the invention;

FIG. 5 is a cross-sectional view of this embodiment, taken along line 5-5 of FIG. 4;

FIG. 6 illustrates a base material in accordance with a further embodiment of the invention;

FIG. 7 illustrates a thermal barrier in accordance with a comparative example; and

FIG. 8 is a cross-sectional view of this example, taken along line 8-8 of FIG. 7.

### DETAILED DESCRIPTION

The present invention relates to thermal barriers comprising phase change materials and methods of manufacturing the same. Thermal barriers in accordance with various embodiments of the invention have the ability to absorb and/or release thermal energy to reduce or eliminate heat flow. The thermal barriers do not suffer from certain disadvantages of traditional insulation, such as, for example, bulkiness and inflexibility. By incorporating phase change materials in a non-encapsulated form, thermal barriers in accordance with various embodiments of the invention may be formed without the additional processing associated with use of micro- or macroencapsulated phase change materials and may provide greater loading levels of the phase change materials. The thermal barriers may be used or incorporated in various products or applications where thermal management is desired. For example, thermal barriers in accordance with various embodiments of the invention may be used in textiles, apparel (e.g., outdoor clothing, drysuits, helmets, protective pads, and protective suits), footwear (e.g., socks, boots, and insoles), medical products (e.g., thermal blankets, therapeutic pads, incontinent pads, and hot/cold packs), containers and packagings (e.g., beverage or food containers, food warmers, seat cushions, insulation for electronics, insulation for storage, and circuit board laminates), buildings (e.g., insulation in walls or ceilings, wallpaper, curtain linings, pipe wraps, carpets, and tiles), appliances (e.g., insulation in house appliances), and other products (e.g., automotive lining material, insulation for engine compartments, insulation for aircraft and spacecraft, sleeping bags, home furnishings, and bedding).

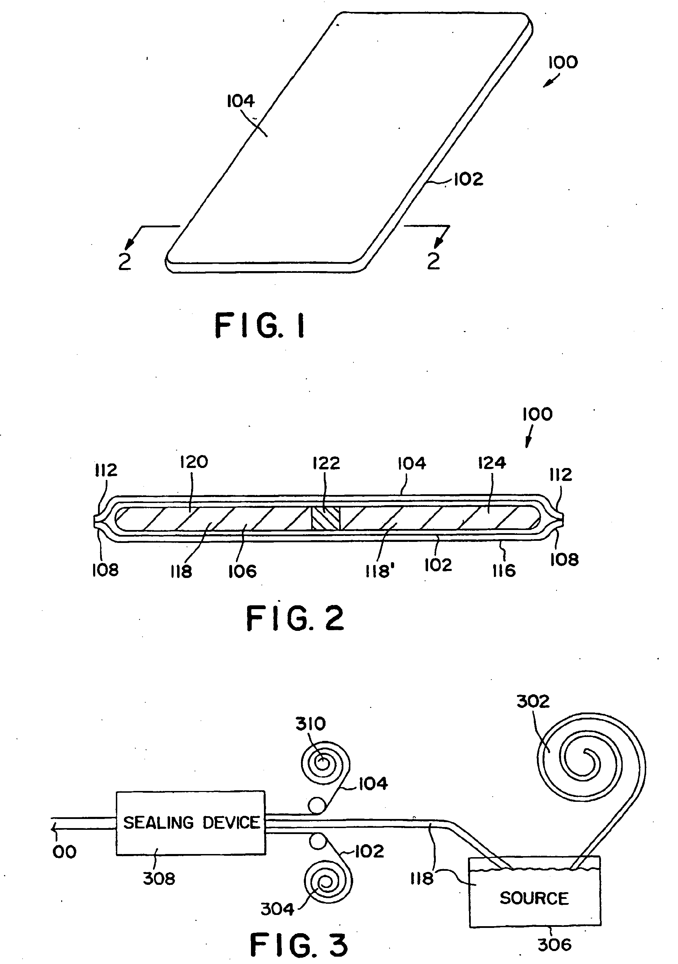

FIG. 1 and FIG. 2 illustrate a thermal barrier 100 in accordance with an embodiment of the invention. The thermal barrier 100 comprises a first barrier layer 102, a second barrier layer 104, and a base material 106 positioned between the first barrier layer 102 and the second barrier layer 104. The thermal barrier 100 may be flexible and may be formed into various shapes, such as, for example, a sheet or roll form.

The base material 106 may be provided in various forms, such as, for example, in the form of foams (e.g., open-celled and closed-cell foams), sheets, films, pellets, fibers, or fabrics. In the present embodiment, the base material 106 comprises a plurality of regions (e.g., a first region 120 and a second region 124), one or more of which may have the same or a different phase change material dispersed therein. For example, with reference to FIG. 2, the thermal barrier 100 comprises a first phase change material 118 dispersed within the first region 120 and a second phase change material 118' dispersed within the second region 124. Depending on the particular application of the thermal barrier 100, the phase change materials 118 and 118' may be the same or different, and the first region 120 and the second region 124 may comprise the same or different materials. While FIG. 2 illustrates two phase change materials 118 and 118', it should be recognized that one or more additional phase change materials may be dispersed within either or both of the first region 120 and the second region 124. Also, it should be recognized that the base material 106 may further comprise one or more additional regions (i.e., in addition to the first region 120 and the second region 124), one or more of which may have a phase change material dispersed therein.

In general, the phase change materials may comprise any material (or mixture of materials) that has the capability of absorbing and/or releasing thermal energy to reduce or eliminate heat flow at or within a temperature stabilizing range. A temperature stabilizing range may comprise a particular transition temperature or range of transition temperatures. The phase change materials may have the same temperature stabilizing range or may have different temperature stabilizing ranges. The phase change materials used in accordance with various embodiments of the invention inhibit the flow of thermal energy through the thermal barrier 100 during a time when one or more of the phase change materials is absorbing or releasing heat, typically as one or more of the phase change materials undergoes a transition between two states (e.g., liquid and solid states, liquid and gaseous states, solid and gaseous states, or two solid states). This action is typically transient, e.g., will occur until a latent heat of the phase change material is absorbed or released during a heating or cooling process. Thermal energy may be stored or removed from one or more of the phase change materials, and one or more of the phase change materials typically can be effectively recharged by a source of heat or cold. By selecting appropriate phase change materials, the thermal barrier 100 may be constructed for use in a particular application where thermal stabilization is desired. As discussed above, the phase change materials selected, for example 118 and 118', may have temperature stabilizing ranges that are different. This configuration may be employed where thermal stabilization is desired at and/or within the two temperature stabilizing ranges.

In the embodiment shown in FIG. 1 and FIG. 2, the phase change materials 118 and 118' may comprise the same liquid/solid phase change material or may comprise different liquid/solid phase change materials. A liquid/solid phase change material typically undergoes a reversible transition between a liquid and a solid state (e.g., melting or freezing transition). Examples of liquid/solid phase change materials suitable for use in the thermal barriers in accordance with various embodiments of the invention include, by way of example and not by limitation, paraffinic hydrocarbons, halogenated hydrocarbons, waxes, oils, hydrated salts, water, fatty acids, fatty acid esters, dibasic acids, dibasic esters, 1-olefins, 1-halides, primary alcohols, alicyclic hydrocarbons, aromatic compounds, clathrates, semi-clathrates, gas clathrates, anhydrides (e.g., stearic anhydride), ethylene carbonate, and polyethlyene glycol.

Table 1 provides a list of exemplary paraffinic hydrocarbons that may be used as the phase change material in the thermal barriers described herein.

**Table 1**

| Compound | No. of Carbon Atoms | Melting Point °C |
|---|---|---|
| n-Octacosane | 28 | 61.4 |
| n-Heptacosane | 27 | 59.0 |
| n-Hexacosane | 26 | 56.4 |
| n-Pentacosane | 25 | 53.7 |
| n-Tetracosane | 24 | 50.9 |
| n-Tricosane | 23 | 47.6 |
| n-Docosane | 22 | 44.4 |
| n-Heneicosane | 21 | 40.5 |
| n-Eicosane | 20 | 36.8 |
| n-Nonadecane | 19 | 32.1 |
| n-Octadecane | 18 | 28.2 |
| n-Heptadecane | 17 | 22.0 |
| n-Hexadecane | 16 | 18.2 |
| n-Pentadecane | 15 | 10.0 |
| n-Tetradecane | 14 | 5.9 |
| n-Tridecane | 13 | -5.5 |

A phase change material can also be a mixture of two or more liquid/solid phase change materials. By selecting two or more different liquid/solid phase change materials (e.g., two different paraffinic hydrocarbons listed in Table 1) and forming a mixture thereof, a temperature stabilizing range can be adjusted over a wide range for any particular application of the thermal barrier 100.

According to the embodiment of the thermal barrier 100 shown in FIG. 1 and FIG. 2, the phase change materials 118 and 118' are in a non-encapsulated form (i.e., the phase change materials 118 and 118' are not micro- or macroencapsulated). Using a phase change material in a non-encapsulated form may reduce expense and loss of the base material 106 and/or the phase change material associated with a micro- or macroencapsulation process and/or associated with incorporating a micro- or macroencapsulated phase change material into the base material 106. In addition, using the phase change material in the non-encapsulated form may enable greater amounts of the phase change material to be dispersed within the base material 106.

As discussed previously, the base material 106 comprises the first region 120 having the first phase change material 118 dispersed therein and the second region 124 having the second phase change material 118' dispersed therein. In general, the first region 120 and the second region 124 may independently comprise any material (or mixture of materials) that provides a matrix within which the non-encapsulated phase change materials 118 and 118' may be respectively dispersed. The first region 120 and the second region 124 may prevent or reduce migration of the non-encapsulated phase change materials 118 and 118' in their respective liquid states within the base material 106, such as, for example, when the thermal barrier 100 is used in a non-horizontal orientation. According to some embodiments of the invention, it is desirable to provide a substantially uniform distribution of the phase change materials 118 and 118' within respective regions 120 and 124 so that heat is not preferentially and undesirably conducted across a portion of the thermal barrier 100 that may contain a lesser amount of the phase change material than another portion. Moreover, the first region 120 and the second region 124 may prevent or reduce deformation (e.g., sagging) of the thermal barrier 100 as a result of migration of the non-encapsulated phase change materials 118 and 118'.

In addition to providing a matrix, either or both of the first region 120 and the second region 124 may be selected in accordance with one or more additional criteria, such as, for example, insulation capacity (i.e., ability to retard heat flow through the thermal barrier 100), compatibility (e.g., inertness) with respect to the phase change material 118 or 118', flexibility, durability, weight, dimension (e.g., width and thickness), and so forth.

As noted above, the first region 120 and the second region 124 of the base material 106 may independently comprise any material (or mixture of materials) that provides a matrix within which the non-encapsulated phase change materials 118 and 118' may be respectively dispersed. Such material can comprise, by way of example and not by limitation, a porous material or a non-porous material. Exemplary porous materials are absorbent and include, by way of example and not by limitation, polymeric materials such as polyurethane, ethylene/vinyl acetate (EVA) copolymer, latex, polyethylene, polypropylene, butyl, silicone, cellulose acetate, neoprene, epoxy, polystyrene, phenolic, polyvinyl chloride (PVC), and other related polymers; cellulose; cotton; silica; carboxymethyl groups; diethylaminoethyl groups; styrene devinylbenzene copolymers with selected functional groups; polyacrylamides and their copolymers; agarose gels; hydroxyapatite; alumina; celotex (sugar cane fiber); methyl cellulose; carboxymethyl cellulose; poly-N-vinyl-2-pyrrodine and its copolymers; hydrogels; dextran; starch grafted polyacrylate polymers; natural and synthetic downs; and ethylene oxides. It should be recognized that a porous material can be a superabsorbant material, which is a type of porous material that absorbs several times (e.g., 20 times) its own weight of a substance to be absorbed (e.g., the phase change material 118 or 118').

Exemplary non-porous materials include, by way of example and not by limitation, polymeric materials such as polyurethane, ethylene/vinyl acetate (EVA) copolymer, latex, polyethylene, polypropylene, butyl, silicone, cellulose acetate, neoprene, epoxy, polystyrene, phenolic, polyvinyl chloride (PVC), natural rubber, synthetic rubber, and other related polymers.

As shown in FIG. 2, the base material 106 further comprises a barrier zone 122 separating the first region 120 and the second region 124. In particular, the barrier zone 122 is shown positioned between the first region 120 and the second region 124 to hinder migration of the phase change materials 118 and 118' in their respective liquid states within the base material 106 (e.g., between the first region 120 and the second region 124). As discussed previously, hindering migration may be desirable to provide a substantially uniform distribution of the phase change materials 118 and 118' within respective regions 120 and 124 and may prevent or reduce deformation (e.g., sagging) of the thermal barrier 100 as a result of migration of the phase change materials 118 and 118'. In addition, the barrier zone 122 may prevent or reduce contact between the phase change materials 118 and 118', which contact may adversely affect the functioning of the phase change material 118 or 118'.

In general, the barrier zone 122 may comprise any material (or mixture of materials) that acts as a barrier to the phase change material 118 or 118' in its liquid state. In some embodiments of the invention, the barrier zone 122 may be impermeable to the phase change material 118 or 118' in its liquid state, while in other embodiments of the invention the barrier zone 122 can have varying degrees of impermeability, depending on the particular application and on the nature of the first region 120 and/or the second region 124. For instance, a lesser degree of impermeability may be desirable if the first region 120 and the second region 124 comprise a porous material that absorbs and strongly retains the phase change materials 118 and 118', thus hindering the phase change materials' ability to migrate within the base material 106.

According to some embodiments of the invention, the barrier zone 122 may comprise the same material (or mixture of materials) that comprises either or both the first region 120 and the second region 124 but which has a lower permeability with respect to the phase change material 118 or 118' in its liquid state. For example, the barrier zone 122 may be formed by applying thermal energy (e.g., heat) or electromagnetic energy (e.g., radio frequency energy) to a portion of an untreated base material (e.g., an open-celled foam) to render that portion less permeable to the phase change material 118 or 118'. As one of ordinary skill in the art will understand, applying thermal or electromagnetic energy may alter the structure of a porous material to render it less permeable to a liquid:

According to other embodiments of the invention, the barrier zone 122 may comprise a non-porous material and may be applied, laminated, or otherwise bonded in a conventional manner to the first region 120 and the second region 124 in the configuration shown in FIG. 2. Exemplary non-porous materials have been discussed previously in connection with the first region 120 and the second region 124.

With reference to FIG. 2, the first barrier layer 102 is bonded to the second barrier layer 104 to enclose or seal the base material 106 and the phase change materials 118 and 118'. More particularly, peripheral portion 108 of the first barrier layer 102 is bonded to peripheral portion 112 of the second barrier layer 104 to enclose the base material 106 and the phase change materials 118 and 118'. Either or both of the barrier layers 102 and 104 may be bonded to the base material 106 via any conventional method, provided such bonding does not adversely interfere with the functioning of the phase change material 118 or 118'.

In general, the first barrier layer 102 and the second barrier layer 104 may independently comprise any material (or mixture of materials) that acts as a barrier to the phase change material 118 or 118' in its liquid state and/or is sealable to enclose the base material 106 and the phase change materials 118 and 118' within the thermal barrier 100.
In order to prevent leakage of the phase change materials 118 and 118', the first barrier layer 102 and the second barrier layer 104 typically act as barriers to the phase change materials 118 and 118' and are bonded to one another so as to enclose the base material 106 and the phase change materials 118 and 118' in an airtight seal. In some embodiments of the invention, the first barrier layer 102 and the second barrier layer 104 may be impermeable to the phase change material 118 or 118' in its liquid state, while in other embodiments of the invention the barriers layers can have varying degrees of impermeability, depending on the particular application and on the nature of the first region 120 and/or the second region 124. For instance, a higher degree of impermeability may be desirable if a region comprises a porous material, since the phase change material 118 or 118' in its liquid state may migrate to a surface of the region and may otherwise leak out of the thermal barrier 100.

Certain phase change materials may have a tendency to absorb moisture and/or interact with contaminants from an outside environment (e.g., air), which can reduce effectiveness of the phase change materials over time. Hence, according to some embodiments of the invention, it may be desirable for the first barrier layer 102 and the second barrier layer 104 to further act as barriers to such moisture and/or contaminants. A required degree of impermeability to such moisture and/or contaminants may vary depending on the particular application (e.g., depending on degree of exposure to moisture).

In addition to providing barriers and/or being sealable, either or both of the first barrier layer 102 and the second barrier layer 104 may be selected in accordance with one or more additional criteria, such as, for example, insulation capacity (i.e., ability to retard heat flow through the thermal barrier 100), compatibility (e.g., inertness) with respect to the phase change material, flexibility, durability, weight, dimension (e.g., width and thickness), and so forth.

The first barrier layer 102 and the second barrier layer 104 may independently comprise, by way of example and not by limitation, a non-porous material or a porous material. In addition, the first barrier layer 102 and the second barrier layer 104 may be respectively and independently provided in various forms, such as, for example, in the form of foams (e.g., open-celled and closed-celled foams), sheets, films, or fabrics.

In particular, the first barrier layer 102 and the second barrier layer 104 may independently comprise a polymeric material, such as, by way of example and not by limitation, polyurethane, ethylene/vinyl acetate (EVA) copolymer, latex, polyethylene, polypropylene, butyl, silicone, cellulose acetate, neoprene, epoxy, polystyrene, phenolic, polyvinyl chloride (PVC), natural rubber, synthetic rubber, and other related polymers. The first barrier layer 102 and the second barrier layer 104 may comprise the same or different polymeric materials. In one embodiment of the invention, the first barrier layer 102 and the second barrier layer 104 comprise flexible, thin, and durable films that provide adequate barriers to the phase change material in its liquid state and are sealable by a conventional method. In another embodiment of the invention, either or both the first barrier layer 102 and the second barrier layer 104 may comprise fibers (e.g., fine, high-density fibers comprising polyethylene) that are randomly or non-directionally distributed and are fused or bonded together, such as, for example, by heat and pressure. An example of such a configuration for the first barrier layer 102 and/or the second barrier layer 104 is Tyvek® brand protective material, which is available from DuPont.

Either or both the first barrier layer 102 and the second barrier layer 104 may also be thermally reflective. For example, as shown in FIG. 2, the first barrier layer 102 may comprise a thermally reflective layer 116. In general, the thermally reflective layer 116 may comprise any material (or mixture of materials) that provides for improved environmental buffering by reflecting and/or retaining thermal energy (e.g., by reducing radiant heat loss or absorption). In the present embodiment, the thermally reflective layer 116 comprises a layer of a metallic material (e.g., aluminum), which may be formed, for example, as a coating on an outer surface of another layer (e.g., a film) comprising the first barrier layer 102. It should be recognized that the thermally reflective layer 116 may, alternatively or in conjunction, be formed as a coating on an inner surface of another layer comprising the first barrier layer 102 or as an internal layer within the first barrier layer 102. In addition, a material (or mixture of materials) may be incorporated into the first barrier layer 102 to render it thermally reflective. Also, it should be recognized that the thermal barrier 100 may, alternatively or in conjunction, further comprise a separate thermally reflective layer positioned adjacent and laminated or otherwise bonded to either or both the first barrier layer 102 and the second barrier layer 104.

FIG. 3 illustrates a method of forming a thermal barrier (e.g., the thermal barrier 100), according to an embodiment of the invention. For ease of discussion of the present embodiment, reference will be simply made to a single phase change material 118. However, as discussed below, embodiments of the invention also encompass methods to form the thermal barrier 100 where several phase change materials may be used.

Initially, the method comprises providing the phase change material 118, which may comprise one or more liquid/solid phase change materials. In particular, the phase change material 118 may comprise a mixture of two or more different liquid/solid phase change materials (e.g., two different paraffinic hydrocarbons) that are mixed to a desired ratio to obtain a desired temperature stabilizing range. The phase change material 118 may be provided in a non-encapsulated liquid form, such as, for example, by melting the phase change material 118 into its liquid state or by dissolving the phase change material 118 in a solvent. In the embodiment shown in FIG. 3, the phase change material 118 is provided in its liquid state by the source 306.

Next, the non-encapsulated phase change material 118 is incorporated into an untreated base material to disperse the non-encapsulated phase change material 118 within the untreated base material. In some embodiments of the invention, the untreated base material comprises a porous material and may be provided in various forms, such as, for example, in the form of foams (e.g., open-celled and closed-cell foams), sheets, films, pellets, fibers, or fabrics. The untreated base material may be impregnated with the non-encapsulated phase change material 118 in a liquid form. This impregnation may be accomplished in various ways. In the embodiment shown in FIG. 3, the untreated base material (e.g., an open-celled foam) is advanced from roll 302 and is submersed, either partially or fully, in the molten phase change material 118 in the source 306. While submersed, the untreated base material may be run through a nip roller or other mechanism to facilitate drawing the phase change material 118 into the untreated base material. Another exemplary way of impregnating the untreated base material comprises coating the untreated base material with the phase change material 118 in a liquid form and drawing the phase change material 118 into the untreated base material under vacuum conditions. A further exemplary way comprises heating the untreated base material to a temperature not in excess of a softening temperature for the untreated base material and contacting the untreated base material with the phase change material 118 in a liquid form. When subsequently passed through a cooling chamber, the phase change material 118 may be drawn into the untreated base material by cooling air. As a still further example, the untreated base material may be impregnated with the phase change material 118 by spraying the phase change material 118 in a liquid form onto the untreated base material. The phase change material 118 is typically sprayed in measured or controlled quantities to disperse a desired amount and/or a desired distribution of the phase change material 118 in the untreated base material. It should be recognized that a solvent, if present, may be removed following impregnation of the untreated base material by, for example, evaporating the solvent.

The impregnated base material may then be advanced towards a sealing device 308 along with the first barrier layer 102 and the second barrier layer 104. As illustrated in FIG. 3, the impregnated base material may be positioned between the first barrier layer 102 and the second barrier layer 104. In particular, the impregnated base material is advanced from the source 306, and the first barrier layer 102 and the second barrier layer 104 are advanced from respective rolls 304 and 310 towards each other to sandwich the impregnated base material. It should be recognized that the first barrier layer 102 and the second barrier layer 104 need not be advanced to underlie and overlie the impregnated base material at the same time and/or same location along the length of the impregnated base material. For instance, the first barrier layer 102 may be initially positioned to underlie the impregnated base material, and the second barrier layer 104 may be subsequently positioned to overlie the impregnated base material. Moreover, it should be recognized that either or both of the barrier layers 102 and 104 may be bonded, either permanently or temporarily, to the untreated base material before it is impregnated with the phase change material 118. Typically, a sufficient amount of the untreated base material may need to be exposed to enable it to be impregnated with the phase change material 118.

Next, the barrier zone 122 may be formed, for example, by applying thermal energy (e.g., heat) or electromagnetic energy (e.g., radio frequency energy) to render a portion of the impregnated base material less permeable to the phase change material 118 in its liquid state. This thermal or electromagnetic energy may be applied at the sealing device 308. The base material 106 comprising the first region 120, the barrier zone 122, and the second region 124 is thus formed, wherein the first region 120 and the second region 124 are impregnated with the phase change material 118.

Once formed, the base material 106 is positioned between the first barrier layer 102 and the second barrier layer 104, and the first barrier layer 102 is bonded to the second barrier layer 104 to enclose the base material 106 and the phase change material 118 to form the thermal barrier 100. As discussed previously in connection with FIG. 1 and FIG. 2, the first barrier layer 102 may be bonded to the second barrier layer 104 at their respective peripheral portions 108 and 112. Bonding of the barrier layers 102 and 104 to one another may be accomplished via any method to enclose the base material 106 and the phase change material 118 within the thermal barrier 100 and/or to provide an airtight seal to prevent or reduce leakage or exposure of the phase change material 118 to environmental moisture or contaminants. For example, bonding may be accomplished by applying thermal energy (e.g., heat), by applying electromagnetic energy (e.g., radio frequency energy), and/or by applying an adhesive to either or both peripheral portions 108 and 112. More particularly, bonding of the barrier layers 102 and 104 to one another may be accomplished at the sealing device 308 and may be performed separate from or in conjunction with forming the barrier zone 122. The resulting thermal barrier 100 may be cut into segments of predetermined lengths or may be collected into a roll.

As discussed above, embodiments of the invention also encompass methods to form the thermal barrier 100 where different phase change materials are used. One exemplary method of forming this thermal barrier 100 comprises providing two phase change materials, 118 and 118', in liquid forms and impregnating respective regions of an untreated base material with the two phase change materials 118 and 118'. For instance, the first phase change material 118 may be sprayed onto a first region of the untreated base material, and the second phase change material 118' may be sprayed onto a second region of the untreated base material. The impregnated base material may then be processed as discussed above to form the barrier zone 122 in between the two regions.

According to some embodiments of the invention, the base material 106 comprising the first region 120, the barrier zone 122, and the second region 124 may be initially formed, and then either or both of the first region 120 and the second region 124 may be impregnated with the phase change material 118. For instance, an untreated base material may be provided, and the base material 106 may be formed by applying thermal energy (e.g., heat) or by applying electromagnetic energy (e.g., radio frequency energy) to render a portion of the untreated base material less permeable to the phase change material 118 in its liquid state. Either or both of the first region 120 and the second region 124 may then be impregnated with the phase change material 118 in a liquid form. As another example, the base material 106 may be formed by laminating or otherwise bonding the first region 120, the barrier zone 122, and the second region 124 together. Alternatively, the first region 120, the barrier zone 122, and the second region 124 may be sequentially cast adjacent one another and allowed to fully solidify when all regions 120 and 124 and the barrier zone 122 have been cast. Here, the first region 120 and the second region 124 may comprise the same or different porous materials, while the barrier zone 122 may comprise a non-porous material. The resulting base material 106 may then be impregnated with the phase change material 118 in a liquid form. Once formed and impregnated with the phase change material 118, the base material 106 may be positioned between the two barrier layers 102 and 104, and the two barrier layers 102 and 104 may be bonded to one another to enclose the base material 106 and the phase change material 118 to form the thermal barrier 100. It should be noted that two or more non-encapsulated phase change materials may be respectively and independently impregnated into either or both the first region 120 and the second region 124. In particular, the first phase change material 118 and the second phase change material 118' may be impregnated into the first region 120 and the second region 124, respectively.

According to other embodiments of the invention, the phase change material 118, either in a liquid or solid form, is initially dispersed in a base material mixture, which comprises a pre-solidified form or processing stage of a base material (e.g., a liquid or solution form of the base material). The phase change material 118 may be provided in a non-encapsulated solid form, such as, for example, in bulk form, sheet form, in pellet form, and/or in powdered form. It should be recognized that the phase change material 118 in pellet form or in powdered form may respectively comprise discrete pellets or particles having a variety of shapes (e.g., spherical, ellipsoidal, or irregularly shaped) and sizes. The base material mixture may comprise a liquid or solution form of one or more polymeric materials, one or more prepolymers, and/or reactants. As one of ordinary skill in the art will understand, the base material mixture may also comprise additional components such as, for example, surfactants and dispersing agents to facilitate wetting, dispersing, and/or to prevent lumping of the phase change material 118. Following dispersal of the phase change material 118, the base material mixture is solidified and may be shaped or molded to form a base material having the phase change material 118 dispersed therein. Generally, this may proceed in accordance with conventional methods, which may, for example, include foam, film, or fiber formation. It should be recognized that this base material may comprise a non-porous material or a porous material having the phase change material 118 dispersed therein. It should also be recognized that the phase change material 118 may be initially impregnated into a porous material, and the impregnated porous material may then be dispersed into a base material mixture.

Once solidified, the base material having the phase change material 118 dispersed therein may be processed in a manner similar to that discussed above to form the base material 106. In particular, the barrier zone 122 may be formed by applying thermal energy (e.g., heat) or by applying electromagnetic energy (e.g., radio frequency energy) to render a portion of this base material less permeable to the phase change material 118 in its liquid state. The resulting base material 106 may then be positioned between the two barrier layers 102 and 104, and the two barrier layers 102 and 104 may be bonded to one another to enclose the base material 106 and the phase change material 118 to form the thermal barrier 100.

It should be recognized that the phase change material 118 may be dispersed in a pre-solidified form of either or both the first region 120 and the second region 124. The base material 106 may then be formed by laminating or otherwise bonding the regions 120 and 124 and the barrier zone 122 together or by sequentially casting the first region 120, the barrier zone 122, and the second region 124 adjacent one another. It should be further noted that two or more non-encapsulated phase change materials may be dispersed in a base material mixture or may be respectively and independently dispersed into pre-solidified forms of either or both the first region 120 and the second region 124. For instance, the first phase change material 118 and the second phase change material 118' may be dispersed into pre-solidified forms of the first region 120 and the second region 124, respectively, which are subsequently solidified and bonded to the barrier zone 122 to form the base material 106.

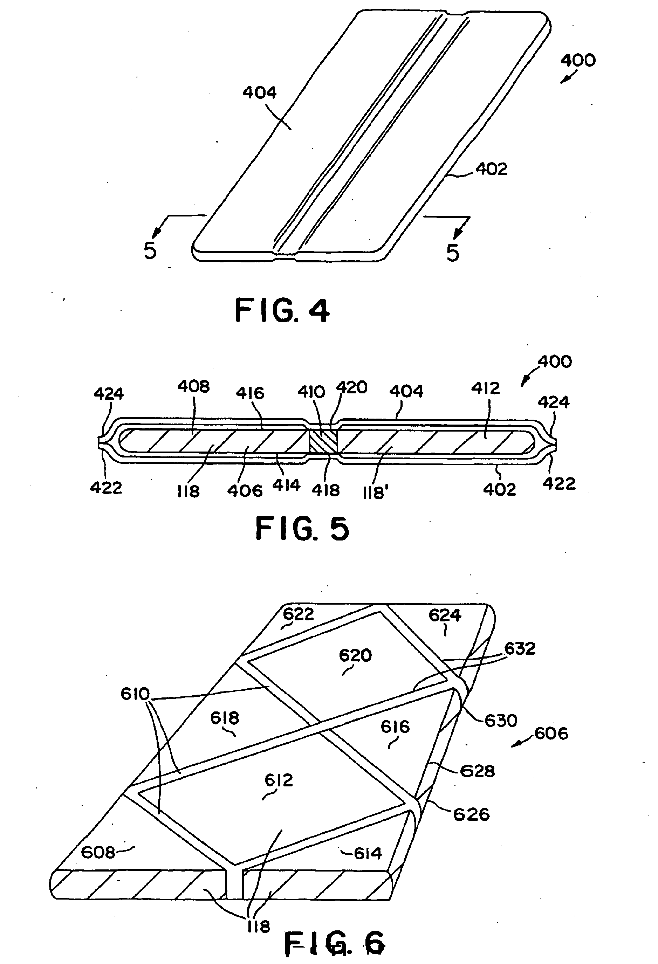

Turning next to FIG. 4 and FIG. 5, a thermal barrier 400 in accordance with another embodiment of the invention is illustrated. As with the embodiment shown in FIG. 1 and - FIG. 2, the thermal barrier 400 comprises a first barrier layer 402, a second barrier layer 404, and a base material 406 positioned between the first barrier layer 402 and the second barrier layer 404. The barrier layers 402 and 404 may comprise the same materials as described above for the barrier layers 102 and 104. In addition, either or both of the barrier layers 402 and 404 may be thermally reflective. The thermal barrier 400 may be flexible and may be formed into various shapes, such as, for example, a sheet or roll form.

In the present embodiment, the base material 406 comprises a first region 408 and a second region 412, one or both of which may have the same or a different non-encapsulated phase change material dispersed therein. More particularly, the first region 408 and the second region 412 may comprise the same or different porous materials, and the first region 408 and the second region 412 are impregnated with the phase change materials 118 and 118', respectively. Exemplary porous materials have been discussed previously in connection with the base material 106.

As shown in FIG. 5, the base material 406 further comprises a barrier zone 410 positioned between and separating the first region 408 and the second region 412 to hinder migration of the phase change materials 118 and 118' in their respective liquid states between the first region 408 and the second region 412. In particular, as shown in FIG. 5, the base material 406 comprises a first surface 414 and a second surface 416, and the barrier zone 410 extends between the two surfaces 414 and 416. More particularly, the first surface 414 and the second surface 416 comprise a first bonding area 418 and a second bonding area 420, respectively, and the barrier zone 410 extends between the first bonding area 418 and the second bonding area 420.

In the present embodiment, the barrier zone 410 may comprise the same material (or mixture of materials) that comprises either or both the first region 408 and the second region 412 but which has a lower permeability with respect to the phase change material 118 or 118' in its liquid state. For example, the barrier zone 410 may be formed by applying thermal energy (e.g., heat) or electromagnetic energy (e.g., radio frequency energy) to render it less permeable to the phase change material 118 or 118'. This thermal or electromagnetic energy may be applied at or in the vicinity of either or both of the first bonding area 418 and the second bonding area 420.

Alternatively, the barrier zone 410 may comprise a non-porous material and may be laminated or otherwise bonded in a conventional manner to the first region 408 and the second region 412 in the configuration shown in FIG. 5. Exemplary non-porous materials have been discussed previously in connection with the base material 106.

As shown in FIG. 5, the first barrier layer 402 is bonded to the second barrier layer 404 to enclose or seal the base material 406 and the phase change materials 118 and 118' within the thermal barrier 400. More particularly, peripheral portion 422 of the first barrier layer 402 is bonded to peripheral portion 424 of the second barrier layer 404 to enclose the base material 406 and the phase change materials 118 and 118'.

In the present embodiment, the first barrier layer 402 and the second barrier layer 404 may be bonded to the base material 406. In particular, interior portions of the first barrier layer 402 and the second barrier layer 404 may be bonded to the base material 406 at the first bonding area 418 and the second bonding area 420, respectively. This effectively defines two compartments such that the barrier zone 410 in cooperation with the barrier layers 402 and 404 bonded thereto prevents or reduces migration of the phase change materials 118 and 118' between the two compartments.

The thermal barrier 400 may be formed, for example, in a manner similar to that discussed in connection with the thermal barrier 100 and FIG. 3 and comprising an additional step of bonding the two barrier layers 402 and 404 to the base material 406. Bonding may be accomplished, for example, by applying thermal energy (e.g., heat), by applying electromagnetic energy (e.g., radio frequency energy), and/or by applying an adhesive to one or more of the barrier layers 402 and 404 and the base material 406. More particularly, bonding of the barrier layers 402 and 404 to the base material 406 may be accomplished at the sealing device 308 separate from or in conjunction with forming the barrier zone 410 or bonding the barrier layers 402 and 404 to one another to enclose the base material 406 within the thermal barrier 400. For instance, thermal energy or electromagnetic energy may be applied at or in the vicinity of either or both the first bonding area 418 and the second bonding area 420 to bond the two barrier layers 402 and 404 to the base material 406 and to form the barrier zone 410.

FIG. 6 illustrates a base material 606 in accordance with a further embodiment of the invention. The base material 606 comprises a plurality of regions 608, 612, 614, 616, 618, 620, 622, and 624, one or more of which may have the same or a different non-encapsulated phase change material dispersed therein. In the present embodiment, these regions may comprise the same or different porous materials. Exemplary porous materials have been discussed previously in connection with the base material 106. Here, one or more of these regions are impregnated with the phase change material 118. Alternatively, one or more different phase change materials can be used in different regions.

The base material 606 further comprises a barrier zone 610, which in the present embodiment is formed in a criss-cross diamond pattern. It should be recognized that the barrier zone 610 may be formed in various alternate regular or irregular patterns, such as, for example, a rectilinear pattern or a honeycomb pattern. With reference to FIG. 6, the barrier zone 610 separates the regions 608, 612, 614, 616, 618, 620, 622, and 624 to hinder migration of the phase change material 118 within the base material 606. More particularly, the barrier zone 610 is shown positioned between a first region 608 and a second region 612 to hinder migration of the phase change material 118 in its liquid state between the first region 608 and the second region 612. The barrier zone 610 may comprise the same material (or mixture of materials) as described above for the barrier zone 122. As shown in FIG. 6, the base material 606 comprises a first surface 626 and a second surface 628, and the barrier zone 610 extends between the two surfaces 626 and 628. More particularly, the first surface 626 and the second surface 628 comprise a first bonding area 630 and a second bonding area 632, respectively, and the barrier zone 610 extends between the first bonding area 630 and the second bonding area 632.

As discussed previously, the barrier zone 610 may be formed, for example, by applying thermal energy (e.g., heat) or by applying electromagnetic energy (e.g., radio frequency energy) to render it less permeable to the phase change material 118 in its liquid state. Alternatively, the base material 606 may be formed by laminating or otherwise bonding the regions 608, 612, 614, 616, 618, 620, 622, and 624 and the barrier zone 610 together or by casting the regions 608, 612, 614, 616, 618, 620, 622, and 624 and the barrier zone 610 in the configuration shown in FIG. 6 and allowing these to fully solidify when all regions and the barrier zone 610 have been cast.

It should be recognized that the base material 606 will typically be positioned and enclosed between two barrier layers, for example, in a manner similar to that shown in FIG. 4 and FIG. 5. A first barrier layer and a second barrier layer may be bonded at their peripheral portions to enclose the base material 606. In addition, the barrier layers may be bonded to the base material 606 at the first bonding area 630 and the second bonding area 632, respectively.

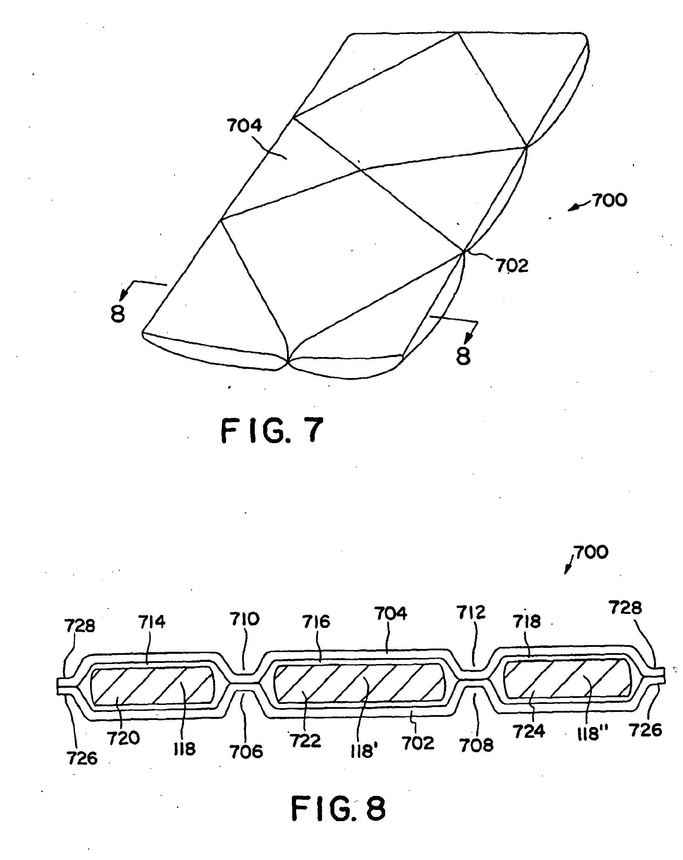

With reference to FIG. 7 and FIG. 8, a thermal barrier 700 in accordance with a comparative example is presented. As with the previously discussed embodiments, the thermal barrier 700 comprises a first barrier layer 702 and a second barrier layer 704 bonded at their respective peripheral portions 726 and 728. The first barrier layer 702 and the second barrier layer 704 may comprise the same materials as described above for the barrier layers 102 and 104. Either or both of the barrier layers 702 and 704 may be thermally reflective. The thermal barrier 700 may be flexible and may be formed into various shapes, such as, for example, a sheet or roll form.

In the present example, interior portions (e.g., interior portions 706 and 708) of the first barrier layer 702 are bonded to interior portions (e.g., interior portions 710 and 712) of the second barrier layer 704 in a particular sealing pattern. In the example shown in FIG. 7 and FIG. 8, this sealing pattern comprises a criss-cross diamond pattern. It should be recognized that various alternate regular or irregular sealing patterns may be formed, such as, for example, a rectilinear pattern or a honeycomb pattern. This sealing pattern may be used to prevent or reduce migration of one or more phase change materials (e.g., phase change materials 118, 118', and 118") enclosed within the thermal barrier 700. Furthermore, this sealing pattern may also serve to enhance flexibility of the thermal barrier 700, such as by facilitating bending of the thermal barrier 700 along a portion or portions of the sealing pattern.

With reference to FIG. 8, interior portions 706 and 708 of the first barrier layer 702 are bonded to interior portions 710 and 712 of the second barrier layer 704 to define a plurality of compartments 714, 716, and 718. A plurality of base materials 720, 722, and 724, one or more of which may have the same or a different phase change material dispersed therein, is shown positioned between the barrier layers 702 and 704, and each base material 720, 722, or 724 is enclosed within a respective compartment 714, 716, or 718. In the present example, non-encapsulated phase change materials 118, 118', and 118" are dispersed in the base materials 720, 722, and 724, respectively, and the compartments 714, 716, and 718 are non-communicating, such that, for example, the phase change material 118 is prevented from migrating between compartments or to leak out of the thermal barrier 700. Depending on the particular application of the thermal barrier 700, the base materials 720, 722, and 724 may comprise the same or different materials. Also, the phase change materials 118, 118', and 118" may be the same or different.

The base materials 720, 722, and 724 may be independently provided in various forms, such as, for example, in the form of foams (e.g., open-celled and closed-cell foams), sheets, films, pellets, fibers, fabrics, and particles (e.g., silica particles, such as precipitated silica particles, fumed silica particles, and mixtures thereof; zeolite particles; carbon particles, such as graphite particles, activated carbon particles, and mixtures thereof; and particles made of absorbent materials). The base materials 720, 722, and 724 may independently comprise any material (or mixture of materials) that provides a matrix within which the non-encapsulated phase change materials 118, 118', and 118" may be respectively dispersed, such as for example, a porous material or a non-porous material. Exemplary porous materials and non-porous materials have been discussed previously in connection with the base material 106. It should be recognized that the base materials 720, 722, and 724 may be different. For instance, a first base material 720 and a second base material 722 may comprise a polyurethane foam and a polyethylene foam, respectively, or may comprise a polyurethane foam and a polyurethane film, respectively.

While FIG. 8 illustrates three phase change materials 118, 118', and 118", it should be recognized that one or more additional phase change materials may be dispersed within one or more of the base materials 720, 722, and 724. Moreover, it should be recognized that either or both of the barrier layers 702 and 704 may be bonded to one or more of the base materials 720, 722, and 724.

The thermal barrier 700 may be formed, for example, in a manner similar to that discussed in connection with the thermal barrier 100 and FIG. 3 and comprising an additional step of bonding interior portions (e.g., the interior portions 706 and 708) of the first barrier layer 702 to interior portions (e.g., the interior portions 710 and 712) of the second barrier layer 704 in a particular sealing pattern to define a plurality of compartments (e.g. the compartments 714, 716, and 718). For ease of discussion of the present example, reference will be simply made to a single phase change material 118. However, as discussed below, several phase change materials may be used to form the thermal barrier 700.

Initially, the non-encapsulated phase change material 118 is incorporated into an untreated base material to disperse the non-encapsulated phase change material 118 within the untreated base material. The untreated base material may comprise a porous material and may be provided in various forms, such as, for example, in the form of foams (e.g., open-celled and closed-cell foams), sheets, films, pellets, fibers, fabrics, and particles. The untreated base material may be impregnated with the phase change material 118 in a liquid form (e.g., from the source 306), and the impregnated base material may be advanced towards a sealing device (e.g., the sealing device 308) along with the first barrier layer 702 and the second barrier layer 704. The impregnated base material may be positioned between the first barrier layer 702 and the second barrier layer 704. The impregnated base material may then be partitioned into the plurality of base materials 720, 722, and 724, one or more of which may be impregnated with the phase change material 118. Partitioning may be accomplished, for example, by applying thermal energy (e.g., heat) or by applying electromagnetic energy (e.g., radio frequency energy). This thermal or electromagnetic energy may be applied at the sealing device 308 as part of or in conjunction with bonding the two barrier layers 702 and 704 to one another. It should be recognized that the impregnated base material may, alternatively, be partitioned via any conventional method into the plurality of base materials 720, 722, and 724 prior to reaching the sealing device 308. Also, it should be recognized that partitioning need not be performed where the base materials 720, 722, and 724 comprise particles that are impregnated with the phase change material 118. In addition, it should be recognized that either or both of the barrier layers 702 and 704 may be bonded, either permanently or temporarily, to the untreated base material before it is impregnated with the phase change material 118.

The base materials 720, 722, and 724 impregnated with the phase change material 118 are positioned between the first barrier layer 702 and the second barrier layer 704, around which the first barrier layer 702 is bonded to the second barrier layer 704 to enclose the base materials 720, 722, and 724 within respective compartments 714, 716, and 718. Bonding of the barrier layers 702 and 704 to one another may be accomplished via any method to prevent or reduce migration of the phase change material 118 within the thermal barrier 700 and/or to provide an airtight seal to prevent or reduce leakage or exposure of the phase change material 118 to environmental moisture or contaminants. For example, bonding may be accomplished by applying thermal energy (e.g., heat), by applying electromagnetic energy (e.g., radio frequency energy), and/or by applying an adhesive to either or both of the barrier layers 702 and 704. As discussed previously, bonding of the barrier layers 702 and 704 to one another may be accomplished at the sealing device 308 separate from or in conjunction with the process used to partition an impregnated base material into the plurality of impregnated base materials 720, 722, and 724. The resulting thermal barrier 700 may be cut into segments of predetermined lengths or may be collected into a roll.

As discussed above, the thermal barrier 700 may be formed where two or more of the phase change materials 118, 118', and 118" are different. One method of forming this thermal barrier 700 comprises providing the phase change material in a liquid form and impregnating respective regions of an untreated base material with the phase change material. The impregnated base material may then be partitioned as discussed above to form the base materials 720, 722, and 724 impregnated with the corresponding phase change materials 118, 118', and 118".

The plurality of base materials 720, 722, and 724 may be initially provided, and one or more of the base materials 720, 722, and 724 may be impregnated with the phase change material 118. Alternatively, a plurality of different phase change materials in a non-encapsulated form may be impregnated into a same base material or within respective base materials. In particular, the plurality of base materials 720, 722, and 724 may be provided and impregnated with the phase change materials 118, 118', and 118", respectively. Once impregnated, the base materials 720, 722, and 724 may be positioned between the first barrier layer 702 and the second barrier layer 704, and the first barrier layer 702 may be bonded to the second barrier layer 704 to enclose the base materials 720, 722, and 724 within respective compartments 714, 716, and 718 to form the thermal barrier 700.

The phase change material 118, either in liquid or solid form, may be initially dispersed in a base material mixture, and the base material mixture may then be solidified and shaped or molded to form a base material having the phase change material 118 dispersed therein. Alternatively, a plurality of different phase change materials (e.g., the phase change materials 118, 118', and 118") in a non-encapsulated form may be dispersed in a base material mixture, which is then solidified to form a base material having the phase change materials dispersed therein. This base material may then be partitioned into the plurality of base materials 720, 722, and 724, around which the first barrier layer 702 is bonded to the second barrier layer 704 to enclose the base materials 720, 722, and 724 within respective compartments 714, 716, and 718. It should be recognized that a plurality of non-encapsulated phase change materials (e.g., the phase change materials 118, 118', and 118") may be respectively dispersed into pre-solidified forms of the base materials 720, 722, and 724, which are subsequently solidified to form the base materials 720, 722, and 724.

Various other embodiments of the thermal barrier may be formed. For instance, in conjunction with one or more phase change materials in a non-encapsulated form, a thermal barrier according to some embodiments of the invention may comprise a containment structure that encapsulates, contains, surrounds, or absorbs a phase change material. The containment structure may facilitate handling of the phase change material, offer a degree of protection to the phase change material, or reduce or prevent leakage of the phase change material from the thermal barrier. As an example of the containment structure, the thermal barrier may comprise a plurality of microcapsules that contain the phase change material, which microcapsules containing the phase change material may be coated onto or dispersed within a base material comprising the thermal barrier. In forming the thermal barrier according to an embodiment of the invention, the microcapsules containing the phase change material may be initially dispersed in a base material mixture, and the base material mixture may then be solidified and shaped or molded to form a base material having the microcapsules containing the phase change material dispersed therein. The microcapsules may be formed as hollow shells enclosing the phase change material and may comprise individual microcapsules formed in a variety of regular or irregular shapes (e.g., spherical, ellipsoidal, and so forth) and sizes. The individual microcapsules may have the same or different shapes or sizes. According to some embodiments of the invention, the microcapsules may have a maximum linear dimension (e.g., diameter) ranging from about 0.01 to about 100 microns. In one embodiment, the microcapsules will have a generally spherical shape and will have a maximum linear dimension (e.g., diameter) ranging from about 0.5 to about 3 microns. Other examples of the containment structure include, by way of example and not by limitation, silica particles (e.g., precipitated silica particles, fumed silica particles, and mixtures thereof), zeolite particles, carbon particles (e.g., graphite particles, activated carbon particles, and mixtures thereof), and absorbent materials (e.g., absorbent polymeric materials, superabsorbent materials, cellulosic materials, poly(meth)acrylate materials, metal salts of poly(meth)acrylate materials, and mixtures thereof). For instance, the thermal barrier may comprise silica particles, zeolite particles, carbon particles, or an absorbent material impregnated with a phase change material, which impregnated particles or absorbent material may be coated onto or dispersed within a base material comprising the thermal barrier. The impregnated particles or absorbent material may be initially dispersed in a base material mixture, and the base material mixture may then be solidified and shaped or molded to form a base material having the impregnated particles or absorbent material dispersed therein.

An embodiment of a thermal barrier with a "bubble-wrap" configuration may be formed, which "bubble-wrap" configuration may be used to prevent or reduce migration of one or more phase change materials enclosed within the thermal barrier. This embodiment of the thermal barrier comprises a first barrier layer and a second barrier layer, either or both of which may be formed with a plurality of depressions. The first barrier layer is bonded to the second barrier layer to define a plurality of compartments, and a plurality of base materials, one or more of which may have the same or a different phase change material dispersed therein, may be positioned within respective compartments. Depending on the application, the base materials may comprise the same or different materials, and the phase change materials may be the same or different. The thermal barrier may be formed, for example, in a manner similar to that discussed in connection the thermal barrier 700 and comprising an additional step of forming the plurality of depressions in either or both the first barrier layer and the second barrier layer in a regular or irregular pattern. The depressions may be formed in a conventional manner. For example, the first barrier layer may be heated till softening, and the first barrier layer may be fed between two pressure forming rollers, One roller may have protrusions extending therefrom, and the other may have cooperating hollows. The plurality of base materials having a respective phase change material dispersed therein may then be positioned in the formed depressions in the first barrier layer, and the second barrier layer may be bonded to the first barrier layer to form the thermal barrier. Bonding may be accomplished at a sealing device (e.g., the sealing device 308) and may occur, for example, by applying thermal energy (e.g., heat), by applying electromagnetic energy (e.g., radio frequency energy), and/or by applying an adhesive to either or both of the barrier layers.

Some embodiments of a thermal barrier may further comprise a structure (e.g., a compartment-defining structure) positioned between two barrier layers and enclosed within the thermal barrier. The compartment-defining structure may be bonded to the two barrier layers to define a plurality of compartments. A plurality of base materials may be positioned within respective compartments, and one or more of the base materials may have the same or a different non-encapsulated phase change material dispersed therein. Depending on the application, the base materials may comprise the same or different materials, and the phase change materials may be the same or different. The compartment-defining structure in cooperation with the barrier layers bonded thereto serves to prevent or reduce migration of the one or more phase change materials enclosed within the thermal barrier. An example of the compartment-defining structure having a corrugated-type shape comprises an interconnecting sheet bonded at alternating offset interior portions of a first barrier layer and a second barrier layer. A further example of the compartment-defining structure comprises a grid having interconnecting walls positioned within the thermal barrier and bonded to interior portions of the two barrier layers. The grid may be formed in various patterns, such as, for example, rectilinear, hexagonal, honeycomb, or other regular or irregular patterns.

Another embodiment of the thermal barrier comprises a compartment-defining structure (e.g., the grid discussed above) positioned between two barrier layers to define a plurality of compartments. In this embodiment, the two barrier layers may be bonded to the compartment-defining structure. A plurality of base materials, one or more of which may have the same or a different non-encapsulated phase change material dispersed therein, may be positioned within respective compartments.

According to some embodiments of the invention, a base material may comprise a plurality of barrier zones that need not be contiguous or placed adjacent with respect to one another. For instance, with reference to FIG. 2, the base material 106 may further comprise a second barrier zone spaced apart from the barrier zone 122, and these two barrier zones may effectively define three regions within the base material 106.

Also, with reference to FIG. 5, the barrier zone 410 may, alternatively or in conjunction, be formed at one or more outer surfaces of the base material 406 (e.g., at either or both the first surface 414 and the second surface 416). This configuration may be used to enclose the phase change material within the base material 406. Alternatively, a sealant material may be applied to the outer surfaces of the base material 406 to enclose the phase change material within the base material 406. In general, any conventional sealant material may be used, provided it acts as a barrier to the phase change material and does not interact adversely with the phase change material.

According to other embodiments of the invention, a non-encapsulated phase change material need not be homogeneously or uniformly dispersed within a base material (e.g., the base material 720) or within a region of a base material (e.g., the first region 120). In particular, the non-encapsulated phase change material may be non-uniformly dispersed within the base material (or a region thereof), such as, for example, to concentrate the phase change material in one or more portions of the base material or to distribute the phase change material in accordance with a concentration profile along one or more directions along the base material. When the base material (or a region thereof) comprises a porous material, the phase change material in its liquid state may tend to migrate, particularly if an orientation of the base material is varied over time. Accordingly, a distribution of the phase change material within the base material (or a region thereof) may also tend to vary over time. When the base material (or a region thereof) comprises a non-porous material, migration of the phase change material may be prevented. Accordingly, a distribution, either uniform or non-uniform, of the phase change material within the base material (or a region thereof) may be static over time. For instance, the phase change material may be dispersed within the base material so as to form various layers with different concentrations of phase change material within the base material. One exemplary method of forming such a configuration comprises laminating or otherwise bonding the various layers of the base material with different concentrations of the phase change material together. Another exemplary method comprises sequentially casting the various layers one on top of another and allowing the various layers to fully solidify when all layers have been cast.

As a final example, an embodiment of the thermal barrier may comprise three or more barrier layers stacked one on top of another. Peripheral portions of the various barrier layers may be bonded to define a plurality of compartments. A plurality of base materials, one or more of which may have the same or a different non-encapsulated phase change material dispersed therein, may be positioned within respective compartments. One or more of the plurality of base materials may comprise a barrier zone, such as, for example, in the configuration shown in FIG. 2, FIG. 5, or FIG. 6. Alternatively or in conjunction, interior portions of two or more barrier layers may be bonded to one another in a particular sealing pattern to define additional compartments. A plurality of base materials, one or more of which may have the same or a different non-encapsulated phase change material dispersed therein, may be positioned within respective additional compartments.

### EXAMPLE

The following example describes specific aspects of the invention to illustrate and provide a description of the invention for those of ordinary skill in the art. The example should not be construed as limiting the invention, as the example merely provides specific methodology useful in understanding and practicing the invention.

### EXAMPLE 1

A 32 kg/m³, 2 millimeter (mm) thick polyurethane foam that is 156 centimeter (cm) wide is heat bonded to a polyurethane film that is approximately 50 micron thick and 160 cm wide. The foam/film system is then run through a nip roller that is partially submersed in a molten phase change material. The phase change material is absorbed into cells of the foam as the foam regains its shape. Excess phase change material is removed under a squeegee set up. A second polyurethane film that is approximately 100 micron thick and 160 cm wide is introduced, and this second film along with the impregnated foam/film system is run through a radio frequency sealing device that bonds peripheral portions of the two films and imprints a criss-cross pattern diamond pattern with points at 15cm (6 inch) intervals across the width of the two films to form a thermal barrier as shown in FIG. 7. The phase change material loading level of the thermal barrier may be as high as about 75% by weight of the thermal barrier and may typically be between about 30% and about 50% by weight of the thermal barrier.

An ordinary artisan should require no additional explanation in developing the thermal barriers and methods described herein but may nevertheless find some helpful guidance in the preparation of these thermal barriers and methods by examining standard reference works in the relevant art. For example, an ordinary artisan may choose to review Payne, et al. U.S. Patent No. 5,532,039, entitled "Thermal Barriers for Buildings, Appliances and Textiles", and Lendell, et al. PCT Publication No. WO 00/61360, entitled "Thermal Managing Foam Insulation"

While the present invention has been described with reference to the specific embodiments thereof, it should be understood by those skilled in the art that various changes may be made and equivalents may be substituted without departing from the scope of the invention as defined by the appended claims. In addition, many modifications may be made to adapt a particular situation, material, composition of matter, method, process step or steps. In particular, while the methods disclosed herein have been described with reference to particular steps performed in a particular order, it will be understood that these steps may be combined, sub-divided, or re-ordored to form an equivalent method without departing from the teachings of the present invention. Accordingly, unless specifically indicated herein, the order and grouping of the steps is not a limitation of the present invention.

## Claims

1. A thermal barrier (100) comprising:
a first barrier layer (102);
a second barrier layer (104);
a base material (106) positioned between the first barrier layer (102) and the second barrier layer (104), wherein the base material (106) comprises a plurality of regions and a barrier zone (122) separating the regions; and
a non-encapsulated phase change material impregnating one or more of the regions, wherein the barrier zone (122) hinders migration of the phase change material in its liquid state within the base material (106), and wherein the first barrier layer (102) is bonded to the second barrier (104) layer to enclose the base material (106).

2. The thermal barrier (100) of claim 1, wherein the regions comprise a porous material.

3. The thermal barrier (100) of claim 1, wherein the regions comprise a material independently selected from the group consisting of polyurethane, ethylene/vinyl acetate copolymer, latex, polyethylene, polypropylene, butyl, silicone, cellulose acetate, neoprene, epoxy, polystyrene, phenolic, polyvinyl chloride; cellulose, cotton, silica, styrene devinylbenzene copolymer, polyacrylamide, polyacrylamide copolymer, agarose gel, hydroxyapatite, alumina, celotex, methyl cellulose, carboxymethyl cellulose, poly-N-vinyl-2-pyrrodine, poly-N-vinyl-2-pyrrodine copolymer, hydrogel, dextran, starch grafted polyacrylate, down, and ethylene oxide.

4. The thermal barrier (100) of claim 1, wherein the barrier zone (122) is Impermeable to the phase change material in its liquid state.

5. The thermal barrier (100) of claim 1, wherein the base material (106) is a foam, sheet, film, or fabric.

6. The thermal barrier (100) of claim 1, wherein the base material (106) further comprises a first surface and a second surface, and wherein the barrier zone (122) extends between the first surface and the second surface.

7. The thermal barrier (100) of claim 6, wherein the first surface and the second surface comprise a first bonding area and a second bonding area, respectively, and wherein the barrier zone (122) extends between the first bonding area and the second bonding area.

8. The thermal barrier (100) of claim 7, wherein the barrier zone (122) is formed by applying thermal energy or electromagnetic energy to at least one of the first bonding area and the second bonding area.

9. The thermal barrier (100) of claim 7, wherein the first barrier layer (102) and the second barrier layer (104) are bonded to the base material (106) at the first bonding area and the second bonding area, respectively.

10. The thermal barrier (100) of claim 1, wherein the phase change material is selected from the group consisting of paraffinic hydrocarbons, halogenated hydrocarbons, waxes, oils, hydrated salts, water, fatty acids, fatty acid esters, dibasic acids, dibasic esters, 1-olefins, 1-halides, primary alcohols, alicyclic hydrocarbons, aromatic compounds, clathrates, semi-clathrates, gas clathrates, stearic anhydride, ethylene carbonate, polyethlyene glycol, and mixtures thereof.

11. The thermal barrier (100) of claim 1, further comprising a second non-encapsulated phase change material impregnating a remaining one or more of the regions, wherein the first phase change material and the second phase change material are different, and wherein the barrier zone (122) further hinders migration of the second phase change material in its liquid state within the base material (106).

12. The thermal barrier (100) of claim 1, wherein the barrier layers are flexible films.

13. The thermal barrier (100) of claim 1, wherein the barrier layers comprise a polymeric material independently selected from the group consisting of polyurethane, ethylene/vinyl acetate copolymer, latex, polyethylene, polypropylene, butyl, silicone, cellulose acetate, neoprene, epoxy, polystyrene, phenolic, polyvinyl chloride, natural rubber, and synthetic rubber.

14. The thermal barrier (100) of claim 1, wherein at least one of the barrier layers is thermally reflective.

15. The thermal barrier (100) of claim 14, wherein said thermally reflective barrier layer comprises a thermally reflective layer or coating.

16. A method of forming a thermal barrier (100), comprising:
(a) Impregnating an untreated base material (106) with a non-encapsulated phase change material (118, 118');
(b) applying thermal energy or electromagnetic energy to the impregnated base material (108) to form a base material (106) comprising a plurality of regions and a barrier zone (122) separating the regions, wherein the regions are impregnated with the phase change material (118, 118'), and wherein the barrier zone (122) hinders migration of the phase change material (118, 118') In Its liquid state within the base material (106);
(c) positioning the base material (106) between a first barrier layer (102) and a second barrier layer (104); and
(d) bonding the first barrier layer (102) to the second barrier layer (104) to enclose the base material (106) to form the thermal barrier (100).

17. The method of claim 16, wherein the untreated base material (106) in (a) comprises a porous material.

18. The method of claim 16, wherein the untreated base material (106) in (a) comprises a material selected from the group consisting of polyurethane, ethylene/vinyl acetate copolymer, latex, polyethylene, polypropylene, butyl, silicone, cellulose acetate, neoprene, epoxy, polystyrene, phenolic, polyvinyl chloride, cellulose, cotton, silica, styrene devinylbenzene copolymer, polyacrylamide, polyacrylamide copolymer, agarose gel, hydroxyapatite, alumina, celotex, methyl cellulose, carboxymethyl cellulose, poly-N-vinyl-2-pyrrodine, poly-N-vinyl-2-pyrrodine copolymer, hydrogel, dextran, starch grafted polyacrylate, down, and ethylene oxide.

19. The method of claim 16, wherein the untreated base material (106) in (a) is a foam, sheet, film, or fabric.

20. The method of claim 16, wherein the barrier zone (122) is impermeable to the phase change material (118, 118') in its liquid state.

21. The method of claim 16, wherein the base material (106) In (b) further comprises a first surface and a second surface, and wherein the barrier zone (122) extends between the first surface and the second surface.

22. The method of claim 21, wherein the first surface and the second surface comprise a first bonding area and a second bonding area, respectively, and wherein the barrier zone (122) extends between the first bonding area and the second bonding area.

23. The method of claim 22, wherein the thermal energy or electromagnetic energy is applied to at least one of the first bonding area and the second bonding area.

24. The method of claim 22, further comprising bonding the first barrier layer (102) and the second barrier layer (104) to the base material (108) at the first bonding area and the second bonding area, respectively.

25. The method of claim 16, wherein the phase change material (118, 118') is selected from the group consisting of paraffinic hydrocarbons, halogenated hydrocarbons, waxes, oils, hydrated salts, water, fatty acids, fatty acid esters, dibasic acids, dibasic esters, 1-olefins, 1-halides, primary alcohols, alicyclic hydrocarbons, aromatic compounds, clathrates, semi-clathrates, gas clathrates, stearic anhydride, ethylene carbonate, polyethlyene glycol, and mixtures thereof.

26. The method of claim 16, wherein the barrier layers are flexible films.

27. The method of claim 16, wherein the barrier layers comprise a polymeric material Independently selected from the group consisting of polyurethane, ethylene/vinyl acetate copolymer, latex, polyethylene, polypropylene, butyl, silicone, cellulose acetate, neoprene, epoxy, polystyrene, phenolic, polyvinyl chloride, natural rubber, and synthetic rubber.

28. The method of claim 16, wherein at least one of the barrier layers is thermally reflective.

29. The method of claim 28, wherein said thermally reflective barrier layer comprises a thermally reflective layer or coating.

## Patentansprüche

1. Wärmesperre (100), umfassend:
eine erste Sperrschicht (102);
eine zweite Sperrschicht (104);
ein Basismaterial (106), das zwischen der ersten Sperrschicht (102) und der zweiten Sperrschicht (104) angeordnet ist, worin das Basismaterial (106) mehrere Regionen und eine die Regionen trennende Sperrzone (122) umfasst; und
ein nicht eingekapseltes Phasenänderungsmaterial, mit dem eine oder mehrere der Regionen imprägniert sind, worin die Sperrzone (122) das Wandern des Phasenänderungsmaterials im flüssigen Zustand innerhalb des Basismaterials (106) verhindert und worin die erste Sperrschicht (102) an die zweite Sperrschicht (104) geklebt ist, um das Basismaterial (106) einzuschließen.

2. Wärmesperre (100) nach Anspruch 1, worin die Regionen ein poröses Material umfassen.

3. Wärmesperre (100) nach Anspruch 1, worin die Regionen ein Material umfassen, das unabhängig voneinander aus der aus Polyurethan, EthylenNinylacetat-Copolymer, Latex, Polyethylen, Polypropylen, Butyl, Silicon, Celluloseacetat, Neopren, Epoxy, Polystyrol, Phenol, Polyvinylchlorid, Cellulose, Baumwolle, Silica, Styrol-Divinylbenzol-Copolymer, Polyacrylamid, Polyacrylamid-Copolymer, Agarosegel, Hydroxyapatit, Aluminiumoxid, Celotex, Methylcellulose, Carboxymethylcellulose, Poly-N-vinyl-2-pyrrodin, Poly-N-vinyl-2-pyrrodin-Copolymer, Hydrogel, Dextran, mit Stärke gepfropftem Polyacrylat, Daunen und Ethylenoxid bestehenden Gruppe ausgewählt ist.

4. Wärmesperre (100) nach Anspruch 1, worin die Sperrzone (122) undurchlässig für das Phasenänderungsmaterial im flüssigen Zustand ist.

5. Wärmesperre (100) nach Anspruch 1, worin das Basismaterial (106) ein Schaum, eine Folie, ein Film oder ein Gewebe ist.

6. Wärmesperre (100) nach Anspruch 1, worin das Basismaterial (106) weiters eine erste Oberfläche und eine zweite Oberfläche umfasst und worin die Sperrzone (122) sich zwischen der ersten Oberfläche und der zweiten Oberfläche erstreckt.

7. Wärmesperre (100) nach Anspruch 6, worin die erste Oberfläche und die zweite Oberfläche eine erste Klebfläche bzw. eine zweite Klebfläche umfassen und worin die Sperrzone (122) sich zwischen der ersten Klebfläche und der zweiten Klebfläche erstreckt.

8. Wärmesperre (100) nach Anspruch 7, worin die Sperrzone (122) gebildet wird, indem Wärmeenergie oder elektromagnetische Energie an zumindest eine aus der ersten Klebfläche und der zweiten Klebfläche angelegt wird.

9. Wärmesperre (100) nach Anspruch 7, worin die erste Sperrschicht (102) und die zweite Sperrschicht (104) an der ersten Klebfläche bzw. an der zweiten Klebfläche an das Basismaterial (106) geklebt sind.

10. Wärmesperre (100) nach Anspruch 1, worin das Phasenänderungsmaterial aus der aus Paraffinkohlenwasserstoffen, halogenierten Kohlenwasserstoffen, Wachsen, Ölen, hydratisierten Salzen, Wasser, Fettsäuren, Fettsäureestern, zweibasigen Säuren, zweibasigen Estern, 1-Olefinen, 1-Halogeniden, primären Alkoholen, alizyklischen Kohlenwasserstoffen, aromatischen Verbindungen, Clathraten, Semiclathraten, Gaschlathraten, Stearinsäureanhydrid, Ethylencarbonat, Polyethylenglykol und Gemischen davon bestehenden Gruppe ausgewählt ist.

11. Wärmesperre (100) nach Anspruch 1, weiters ein zweites nicht eingekapseltes Phasenänderungsmaterial umfassend, mit dem eine oder mehrere restliche Regionen imprägniert sind, worin das erste Phasenänderungsmaterial und das zweite Phasenänderungsmaterial unterschiedlich sind und worin die Sperrzone (122) weiters das Wandern des zweiten Phasenänderungsmaterials im flüssigen Zustand innerhalb des Basismaterials (106) verhindert.

12. Wärmesperre (100) nach Anspruch 1, worin die Sperrschichten flexible Filme sind.

13. Wärmesperre (100) nach Anspruch 1, worin die Sperrschichten ein Polymermaterial umfassen, das unabhängig voneinander aus der aus Polyurethan, EthylenNinylacetat-Copolymer, Latex, Polyethylen, Polypropylen, Butyl, Silicon, Celluloseacetat, Neopren, Epoxy, Polystyrol, Phenol, Polyvinylchlorid, Naturkautschuk und Synthesekautschuk bestehenden Gruppe ausgewählt ist.

14. Sperrschicht (100) nach Anspruch 1, worin zumindest eine der Sperrschichten wärmereflektierend ist.

15. Sperrschicht (100) nach Anspruch 14, worin die wärmereflektierende Sperrschicht eine wärmereflektierende Schicht oder Beschichtung umfasst.

16. Verfahren zur Ausbildung einer Sperrschicht (100), umfassend:
(a) Imprägnieren eines unbehandelten Basismaterials (106) mit einem nicht eingekapselten Phasenänderungsmaterial (118, 118');
(b) Anlegen von Wärmeenergie oder elektromagnetischer Energie an das imprägnierte Basismaterial (106), um ein Basismaterial (106) zu bilden, das mehrere Regionen und eine die Regionen trennende Sperrzone (102) umfasst, worin die Regionen mit dem Phasenänderungsmaterial (118, 118') imprägniert sind und worin die Sperrzone (122) das Wandern des Phasenänderungsmaterials (118, 118') im flüssigen Zustand innerhalb des Basismaterials (106) verhindert;
(c) Positionieren des Basismaterials (106) zwischen einer ersten Sperrschicht (102) und einer zweiten Sperrschicht (104); und
(d) Kleben der ersten Sperrschicht (102) auf die zweite Sperrschicht (104), um das Basismaterial (106) einzuschließen und so die Wärmesperre (100) zu bilden.

17. Verfahren nach Anspruch 16, worin das unbehandelte Basismaterial (106) in (a) ein poröses Material umfasst.

18. Verfahren nach Anspruch 16, worin das unbehandelte Basismaterial (106) in (a) ein Material umfasst, das aus der aus Polyurethan, Ethylen/Vinylacetat-Copolymer, Latex, Polyethylen, Polypropylen, Butyl, Silicon, Celluloseacetat, Neopren, Epoxy, Polystyrol, Phenol, Polyvinylchlorid; Cellulose, Baumwolle, Silica, Styrol-Divinylbenzol-Copolymer, Polyacrylamid, Polyacrylamid-Copolymer, Agarosegel, Hydroxyapatit, Aluminiumoxid, Celotex, Methylcellulose, Carboxymethylcellulose, Poly-N-vinyl-2-pyrrodin, Poly-N-vinyl-2-pyrrodin-Copolymer, Hydrogel, Dextran, mit Stärke gepfropftem Polyacrylat, Daunen und Ethylenoxid bestehenden Gruppe ausgewählt ist.

19. Verfahren nach Anspruch 16, worin das unbehandelte Basismaterial (106) in (a) ein Schaum, eine Folie, ein Film oder ein Gewebe ist.

20. Verfahren nach Anspruch 16, worin die Sperrzone (122) undurchlässig für das Phasenänderungsmaterial (118, 118') im flüssigen Zustand ist.

21. Verfahren nach Anspruch 16, worin das Basismaterial (106) in (b) weiters eine erste Oberfläche und eine zweite Oberfläche umfasst und worin die Sperrzone (122) sich zwischen der ersten Oberfläche und der zweiten Oberfläche erstreckt.

22. Verfahren nach Anspruch 21, worin die erste Oberfläche und die zweite Oberfläche eine erste Klebfläche bzw. eine zweite Klebfläche umfassen und worin die Sperrzone (122) sich zwischen der ersten Klebfläche und der zweiten Klebfläche erstreckt.

23. Verfahren nach Anspruch 22, worin Wärmeenergie oder elektromagnetische Energie an zumindest eine aus der ersten Klebfläche und der zweiten Klebfläche angelegt wird.

24. Verfahren nach Anspruch 22, weiters das Kleben der ersten Sperrschicht (102) und der zweiten Sperrschicht (104) an der ersten Klebfläche bzw. an der zweiten Klebfläche an das Basismaterial (106) umfassend.

25. Verfahren nach Anspruch 16, worin das Phasenänderungsmaterial (118, 118') aus der aus Paraffinkohlenwasserstoffen, halogenierten Kohlenwasserstoffen, Wachsen, Ölen, hydratisierten Salzen, Wasser, Fettsäuren, Fettsäureestern, zweibasigen Säuren, zweibasigen Estern, 1-Olefinen, 1-Halogeniden, primären Alkoholen, alizyklischen Kohlenwasserstoffen, aromatischen Verbindungen, Clathraten, Semiclathraten, Gaschlathraten, Stearinsäureanhydrid, Ethylencarbonat, Polyethylenglykol und Gemischen davon bestehenden Gruppe ausgewählt ist.

26. Verfahren nach Anspruch 16, worin die Sperrschichten flexible Filme sind.

27. Verfahren nach Anspruch 16, worin die Sperrschichten ein Polymermaterial umfassen, das unabhängig voneinander aus der aus Polyurethan, EthylenNinylacetat-Copolymer, Latex, Polyethylen, Polypropylen, Butyl, Silicon, Celluloseacetat, Neopren, Epoxy, Polystyrol, Phenol, Polyvinylchlorid, Naturkautschuk und Synthesekautschuk bestehenden Gruppe ausgewählt ist.

28. Verfahren nach Anspruch 16, worin zumindest eine der Sperrschichten wärmereflektierend ist.

29. Verfahren nach Anspruch 28, worin die wärmereflektierende Sperrschicht eine wärmereflektierende Schicht oder Beschichtung umfasst.

## Revendications

1. Barrière thermique (100) comprenant :
une première couche barrière (102) ;
une seconde couche barrière (104) ;
un matériau de base (106) positionné entre la première couche barrière (102) et la seconde couche barrière (104), où le matériau de base (106) comprend une pluralité de régions et une zone barrière (122) séparant les régions ; et
un matériau à changement de phase non encapsulé imprégnant une ou plusieurs des régions, où la zone barrière (122) empêche la migration du matériau à changement de phase dans son état liquide dans le matériau de base (106), et où la première couche barrière (102) est liée à la seconde couche barrière (104) pour enfermer le matériau de base (106).

2. Barrière thermique (100) selon la revendication 1, dans laquelle les régions comprennent un matériau poreux.

3. Barrière thermique (100) selon la revendication 1, dans laquelle les régions comprennent un matériau indépendamment choisi dans le groupe consistant en le poly(uréthane), un copolymère d'éthylène/acétate de vinyle, un latex, le poly(éthylène), le poly(propylène), le butyle, la silicone, l'acétate de cellulose, le néoprène, l'époxy, le poly(styrène), un composé phénolique, le poly(chlorure de vinyle), la cellulose, le coton, la silice, un copolymère de styrène/divinylbenzène, le poly(acrylamide), un copolymère de poly(acrylamide), le gel d'agarose, l'hydroxyapatite, l'alumine, le celotex, la méthylcellulose, la carboxyméthylcellulose, la poly(N-vinyl-2-pyrrodine), un copolymère de poly(N-vinyl-2-pyrrodine), un hydrogel, le dextrane, le poly(acrylate) greffé sur amidon, le duvet et l'oxyde d'éthylène.

4. Barrière thermique (100) selon la revendication 1, dans laquelle la zone barrière (122) est imperméable au matériau à changement de phase dans son état liquide.

5. Barrière thermique (100) selon la revendication 1, dans laquelle le matériau de base (106) est une mousse, une feuille, un film ou un tissu.

6. Barrière thermique (100) selon la revendication 1, dans laquelle le matériau de base (106) comprend en outre une première surface et une seconde surface, et dans laquelle la zone barrière (122) s'étend entre la première surface et la seconde surface.

7. Barrière thermique (100) selon la revendication 6, dans laquelle la première surface et la seconde surface comprennent une première zone de liaison et une seconde zone de liaison, respectivement, et dans laquelle la zone barrière (122) s'étend entre la première zone de liaison et la seconde zone de liaison.

8. Barrière thermique (100) selon la revendication 7, dans laquelle la zone barrière (122) est formée par l'application d'énergie thermique ou d'énergie électromagnétique à au moins l'une de la première zone de liaison et de la seconde zone de liaison.

9. Barrière thermique (100) selon la revendication 7, dans laquelle la première couche barrière (102) et la seconde couche barrière (104) sont liées au matériau de base (106) au niveau de la première zone de liaison et de la seconde zone de liaison, respectivement.

10. Barrière thermique (100) selon la revendication 1, dans laquelle le matériau à changement de phase est choisi dans le groupe consistant en les hydrocarbures paraffiniques, les hydrocarbures halogénés, les cires, les huiles, les sels hydratés, l'eau, les acides gras, les esters d'acides gras, les acides dibasiques, les esters dibasiques, les 1-oléfines, les 1-halogénures, les alcools primaires, les hydrocarbures alicycliques, les composés aromatiques, les clathrates, les semi-clathrates, les clathrates gazeux, l'anhydride stéarique, le carbonate d'éthylène, le poly(éthylène glycol), et leurs mélanges.

11. Barrière thermique (100) selon la revendication 1, comprenant en outre un second matériau à changement de phase non encapsulé imprégnant une ou plusieurs régions restantes, où le premier matériau à changement de phase et le second matériau à changement de phase sont différents, et où la zone barrière (122) gêne en outre la migration du second matériau à changement de phase dans son état liquide dans le matériau de base (106).

12. Barrière thermique (100) selon la revendication 1, dans laquelle les couches barrière sont des films flexibles.

13. Barrière thermique (100) selon la revendication 1, dans laquelle les couches barrière comprennent un matériau polymère indépendamment choisi dans le groupe consistant en le poly(urêthane), un copolymère d'éthylène/acétate de vinyle, un latex, le poly(éthylène), le poly(propylène), le butyle, la silicone, l'acétate de cellulose, le néoprène, l'époxy, le poly(styrène), un composé phénolique, le poly(chlorure de vinyle), le caoutchouc naturel et le caoutchouc synthétique.

14. Barrière thermique (100) selon la revendication 1, dans laquelle au moins une des couches barrière est thermiquement réfléchissante.

15. Barrière thermique (100) selon la revendication 14, dans laquelle ladite couche barrière thermiquement réfléchissante comprend une couche ou un revêtement thermiquement réfléchissant.

16. Procédé de formation d'une barrière thermique (100), comprenant :
(a) l'imprégnation d'un matériau de base non traité (106) avec un matériau à changement de phase non encapsulé (118, 118') ;
(b) l'application d'énergie thermique ou d'énergie électromagnétique au matériau de base imprégné (106) pour former un matériau de base (106) comprenant une pluralité de régions et une zone barrière (122) séparant les régions, où les régions sont imprégnées du matériau à changement de phase (118, 118'), et où la zone barrière (122) gêne la migration du matériau à changement de phase (118, 118') dans son état liquide dans le matériau de base (106) ;
(c) le positionnement du matériau de base (106) entre une première couche barrière (102) et une seconde couche barrière (104) ; et
(d) la liaison de la première couche barrière (102) à la seconde couche barrière (104) pour enfermer le matériau de base (106) pour former la barrière thermique (100).

17. Procédé selon la revendication 16, dans lequel le matériau de base non traité (106) dans (a) comprend un matériau poreux.

18. Procédé selon la revendication 16, dans lequel le matériau de base non traité (106) dans (a) comprend un matériau choisi dans le groupe consistant en le poly(uréthane), un copolymère d'éthylène/acétate de vinyle, un latex, le poly(éthylène), le poly(propylène), le butyle, la silicone, l'acétate de cellulose, le néoprène, l'époxy, le poly(styrène), un composé phénolique, le poly(chlorure de vinyle), la cellulose, le coton, la silice, un copolymère de styrène/divinylbenzène, le poly(acrylamide), un copolymère de poly(acrylamide), le gel d'agarose, l'hydroxyapatite, l'alumine, le celotex, la méthylcellulose, la carboxyméthylcellulose, la poly(N-vinyl-2-pyrrodine), un copolymère de poly(N-vinyl-2-pyrrodine), un hydrogel, le dextrane, le poly(acrylate) greffé sur amidon, le duvet, et l'oxyde d'éthylène.

19. Procédé selon la revendication 16, dans lequel le matériau de base non traité (106) dans (a) est une mousse, une feuille, un film ou un tissu.

20. Procédé selon la revendication 16, dans lequel la zone barrière (122) est imperméable au matériau à changement de phase (118, 118') dans son état liquide.

21. Procédé selon la revendication 16, dans lequel le matériau de base (106) dans (b) comprend en outre une première surface et une seconde surface, et dans lequel la zone barrière (122) s'étend entre la première surface et la seconde surface.

22. Procédé selon la revendication 21, dans lequel la première surface et la seconde surface comprennent une première zone de liaison et une seconde zone de liaison, respectivement, et dans lequel la zone barrière (122) s'étend entre la première zone de liaison et la seconde zone de liaison.

23. Procédé selon la revendication 22, dans lequel l'énergie thermique ou énergie électromagnétique est appliquée à au moins l'une de la première zone de liaison et de la seconde zone de liaison.

24. Procédé selon la revendication 22, comprenant en outre la liaison de la première couche barrière (102) et de la seconde couche barrière (104) au matériau de base (106) au niveau de la première zone de liaison et de la seconde zone de liaison, respectivement.

25. Procédé selon la revendication 16, dans lequel le matériau à changement de phase (118, 118') est choisi dans le groupe consistant en les hydrocarbures paraffiniques, les hydrocarbures halogénés, les cires, les huiles, les sels hydratés, l'eau, les acides gras, les esters d'acides gras, les acides dibasiques, les esters dibasiques, les 1-oléfines, les 1-halogénures, les alcools primaires, les hydrocarbures alicycliques, les composés aromatiques, les clathrates, les semi-clathrates, les clathrates gazeux, l'anhydride stéarique, le carbonate d'éthylène, le poly(éthylène glycol), et leurs mélanges.

26. Procédé selon la revendication 16, dans lequel les couches barrière sont des films flexibles.

27. Procédé selon la revendication 16, dans lequel les couches barrière comprennent un matériau polymère indépendamment choisi dans le groupe consistant en le poly(uréthane), un copolymère d'éthylène/acétate de vinyle, le latex, le poly(éthylène), le poly(propylène), le butyle, la silicone, l'acétate de cellulose, le néoprène, l'époxy, le poly(styrène), un composé phénolique, le poly(chlorure de vinyle), le caoutchouc naturel et le caoutchouc synthétique.

28. Procédé selon la revendication 16, dans lequel au moins l'une des couches barrière est thermiquement réfléchissante.

29. Procédé selon la revendication 28, dans lequel ladite couche barrière thermiquement réfléchissante comprend une couche ou un revêtement thermiquement réfléchissant.
